# EUROPÄISCHE PATENTANMELDUNG

(11) **EP 1 500 975 A2**
(43) Veröffentlichungstag der Anmeldung: **26.01.2005**
(21) Anmeldenummer: 04016312.3
(22) Anmeldetag: 12.07.2004
(51) Int. Cl.: G03F 7/00

(54) **Verfahren zur Herstellung von optischen Mikrostrukturen**

(30) Priorität: 21.07.2003 DE 10333230; 19.11.2003 DE 10354181
(71) Anmelder: Ingeneric GmbH, 52068 Aachen (DE); SUSS MicroOptics SA, 2007 Neuchatel (CH)
(72) Erfinder: Hämbücker, Stefan, Dr.-Ing., 58642 Iserlohn (DE); Rübenach, Olaf, Dr.-Ing., 52134 Herzogenrath (DE); Sinhoff, Volker, Dr.-Ing., 52146 Würselen (DE); Völkel, Reinhard, Dr.-Ing., 2000 Neuchatel (CH); Eisner, Martin, 2000 Neuchatel (CH); Fischer, Katrin, 2034 Peseux (CH); Weible, Kenneth J., 2000 Neuchatel (CH)
(74) Vertreter: Kohlmann, Kai, Dipl.-Ing.

(57) **Zusammenfassung**

Die Erfindung betrifft ein Verfahren zur Herstellung von Linsen und Linsenarrays, insbesondere für Zylinderlinsen, die als Kollimator der Fast-Axis in Hochleistungsdiodenlasern zum Einsatz gelangen, bei dem in mindestens einem Schritt eine optisch wirksame Oberflächentopographie auf einem Substrat durch ein mechanisches Verfahren erzeugt wird und in mindestens einem weiteren Endbearbeitungsschritt die Oberflächentopographie geglättet wird.

Um die industrielle Herstellung von derartigen Linsen und Linsenarrays mit hoher Präzision und engen Toleranzen zu ermöglichen, wird erfindungsgemäß vorgeschlagen, dass die optisch wirksame Oberflächentopographie fotolithographisch maskiert und durch plasmaunterstütztes Trockenätzen, insbesondere reaktives Ionenätzen oder Plasmaätzen geglättet wird.

## Beschreibung

Die Erfindung betrifft ein Verfahren zur Herstellung optisch wirksamer Mikrostrukturen bei dem in mindestens einem Schritt eine optisch wirksame Oberflächentopographie auf einem Substrat durch ein mechanisches Verfahren erzeugt wird und in mindestens einem weiteren Endbearbeitungsschritt die Oberflächentopographie geglättet wird.

Die Erfindung betrifft insbesondere die Herstellung von Linsen, Linsenarrays und prismatischen Strukturen mit großem Aspektverhältnis, großen Strukturhöhen und mit einer Querschnittsfläche kleiner als 1,5 mm².

Ein typisches Beispiel einer nach dem erfindungsgemäßen Verfahren hergestellten Mikrostruktur ist eine plankonvexe asphärische Zylinderlinse, die als Kollimator der Fast-Axis in Hochleistungsdiodenlasern eingesetzt wird. Um eine maximale Leistungsdichte zu erzielen, muss der hoch divergente Laserstrahl möglichst stark fokussiert werden (vgl. R. Diehl, High-Power Diode Lasers, Fundamentals, Technology, Applications, 78/ Topics in Applied Physics). Um diesen Anforderungen gerecht zu werden, muss die Zylinderlinse außerordentlich genau und mit geringen Toleranzen gefertigt werden. Typische Abmessungen derartiger Zylinderlinsen liegen bei einer Breite von 1 mm, einer Pfeilhöhe (optisch wirksame Strukturhöhe) von 0,3 mm bei einer Gesamthöhe von 0,8 mm und einer Länge von 12 mm.

Die Zylinderlinsen für Hochleistungsdiodenlaser bestehen aus sprödharten Werkstoffen, wie beispielsweise optischen Gläsern oder Quarzglas. Der sprödharte Charakter der Werkstoffe und die große Strukturhöhe der Zylinderlinse machen im Regelfall ein mehrstufiges Herstellungsverfahren erforderlich.

Die spanenden Herstellungsverfahren gliedern sich regelmäßig in die Bearbeitungsschritte Vorschleifen, Feinschleifen und Polieren (vgl. Volker R. Sinhoff, Feinbearbeitung optischer Gläser in Keinserie, WZL - Berichte aus der Produktionstechnik, Band 6/97, Shaker Verlag). Durch das Schleifen als mechanisches Abtragsverfahren wird die optisch wirksame Oberflächentopographie erzeugt, während das Polieren als Endbearbeitungsschritt auf eine Verbesserung der Oberflächenqualität bei gleichzeitiger Erhaltung der Formgenauigkeit zielt.

Durch mechanische Abtragsverfahren wie Schleifen oder das Ultraschallschwingläppen lassen sich zwar die erforderlichen großen Strukturhöhen für Zylinderlinsen fertigen, jedoch ist die erzielbare Oberflächenqualität in der Regel eingeschränkt. Selbst bei der Verwendung von duktilem Schleifen ist in jedem Fall eine Endbearbeitung der Oberflächentopographie erforderlich. Die bekannten mechanischen Endbearbeitungsschritte, z.B. die mechanochemische Politur auf Basis von Suspensionen, ist für die Herstellung von Zylinderlinsen hinsichtlich der erreichbaren Formgenauigkeit und Wirtschaftlichkeit nur bedingt geeignet; sie sind schwierig zu handhaben und lassen sich wirtschaftlich lediglich zur Fertigung von einzelnen Linsen oder Kleinserien verwenden. Die Handhabungsprobleme äußern sich beispielsweise darin, dass bei der Halterung der Linse während der Politur Spannungen auftreten, die zu einer Verformung der Linse führen können. Die Verformungen verursachen geometrische Fehler, die die Qualität der Linse erheblich beeinträchtigen. Des Weiteren ist bei der Politur aufgrund der im Verhältnis zu den Abmessungen der Linse großen Kontaktfläche mit dem Polierwerkzeug eine hinreichende ortsabhängige Steuerung des Materialabtrags kaum möglich. Folglich lassen sich die Anforderungen an die Formgenauigkeit der Linsen nicht befriedigend erfüllen.

Zur Endbearbeitung der optisch wirksamen Struktur stehen noch weitere Verfahren zur Verfügung. In der EP 0664891 B1 wird beispielsweise thermisch induziertes Glätten mittels Elektronenstrahlung beschrieben. Das Verfahren beruht auf einer gezielten Aufschmelzung der Oberfläche. Dadurch heilen oberflächennahe Defekte (Risse) aus. Entscheidender Nachteil dieses Endbearbeitungsschritts ist die Veränderung der Oberflächentopographie. Aufgrund des zähflüssigen Zustands des Werkstoffs während des Glättens versucht das Material den energetisch günstigen Zustand einer Kugel einzunehmen. Dadurch verzerrt sich die während der mechanischen Vorbearbeitung erzielte Abmessung der optisch wirksamen Struktur.

In R. Voelkel, M. Eisner, C. Ossmann, Refractive microlenses for ultra-flat photolithographic projection systems ist ein Herstellungsverfahren für Mikrolinsen beschrieben, bei dem eine Schicht ( etwa 1 µm bis 50 µm Dicke) Photoresistlack auf einem beidseitig polierten Substrat aus Quarzglas aufgebracht wird. Sodann wird der Lack durch eine Maske hindurch entwickelt und dadurch eine Anordnung von Zylindern aus Photoresistlack auf dem Substrat erzeugt. Die Zylinder aus Photoresistlack werden durch plasmaunterstütztes Ätzen, nämlich reaktives Ionenätzen in das Quarzglas übertragen. Die Atome von der Photoresistlack-Oberfläche und dem Quarzglas werden durch die Ionen gleichzeitig abgetragen, bis die Linse vollständig in das Substrat geätzt ist. Da die Ätzrate des Photoresistlacks und des Substrates sowie die Brechungsindizes nicht genau übereinstimmen, kann die Form der Linse nach dem Ionenätzen geringfügig verändert sein. Diesen Formveränderungen versucht man vorzubeugen, in dem die Ätzrate während des Ätzens geändert wird. Ein Endbearbeitungsschritt ist bei diesem Verfahren nicht erforderlich, da die Oberflächenbeschaffenheit des beidseitig polierten Substrats durch das reaktive Ionenätzen nahezu nicht verändert wird. Dieses Herstellungsverfahren weist gegenüber den eingangs beschriebenen mechanischen Herstellungsverfahren den Vorteil auf, dass sich mit hoher Präzision wirtschaftlich große Mengen optisch wirksamer Strukturen herstellen lassen. Nachteilig ist allerdings die geringe Ätzrate und die Begrenzung der mit diesem Verfahren realisierbaren Strukturhöhe auf maximal 0,1 mm. Asphärische Zylinderlinsen, die als Kollimator der Fast-Axis in Hochleistungsdiodenlasern zum Einsatz gelangen, lassen sich daher mit diesem Verfahren nicht herstellen.

Ausgehend von diesem Stand der Technik liegt der Erfindung die Aufgabe zu Grunde, ein Verfahren anzugeben, das die industrielle Herstellung von optisch wirksamen Mikrostrukturen, insbesondere strukturierten Arrays mit hoher Präzision und engen Toleranzen erlaubt. Mit dem Verfahren sollen sich insbesondere auch Strukturhöhen von mehr als 0,1 mm industriell fertigen lassen.

Diese Aufgabe wird erfindungsgemäß bei einem Verfahren der eingangs erwähnten Art dadurch gelöst, dass die optisch wirksame Oberflächentopographie fotolithographisch maskiert und durch Ätzen, insbesondere durch plasmaunterstütztes Trockenätzen geglättet wird. Als Trockenätzverfahren kommen insbesondere das Plasmaätzen oder reaktive Ionenätzen in Betracht.

In mindestens einem ersten Schritt wird durch ein mechanisches Verfahren, insbesondere abbildendes Schleifen, Ultraschallschwingläppen oder Laserabtragen die optisch wirksame Oberflächentopographie auf dem Substrat erzeugt; in mindestens einem weiteren Endbearbeitungsschritt werden die durch das mechanische Abtragsverfahren entstandenen Oberflächendefekte durch Ätzen, insbesondere durch plasmaunterstütztes Trockenätzen geglättet. Als Trockenätzverfahren kommen insbesondere das Plasmaätzen oder reaktive Ionenätzen in Betracht.

Bei plasmaunterstütztem Trockenätzen wird Material durch ein gasförmiges Ätzmedium abgetragen, wobei der Angriff der in einem Plasma erzeugten ätzaktiven Teilchen nach Büttgenbach, Stephanus: Mikromechanik: Einführung in Technologie und Anwendungen - 2. Aufl. - Stuttgart : Teubner, 1994 chemischer, physikalischer oder gemischt physikalischchemischer Natur sein kann.

Für das erfindungsgemäße Verfahren haben sich das Plasmaätzen und das reaktive Ionenätzen als vorteilhaft herausgestellt. Beide Verfahren beruhen auf einem gemischt physikalisch/chemischen Ätzmechanismus. Beim Plasmaätzen sind die ätzaktiven Teilchen reaktive Radikale, schwach ionenunterstützt. Beim reaktiven Ionenätzen sind die ätzaktiven Teilchen reaktive Radikale, stark ionenunterstützt mit reaktiven Ionen.

In dem Endbearbeitungsschritt ist keine Formkorrektur erforderlich. Abweichend zu dem in R. Voelkel, M. Eisner, C. Ossmann, Refractive microlenses for ultra-flat photolithographic projection systems beschriebenen Verfahren, wird das reaktive Ionenätzen bzw. das Plasmaätzen bei dem erfindungsgemäßen Verfahren zweckentfremdet zum Glätten einer bereits strukturierten Oberflächentopographie in einem Substrat und nicht zum Übertragen einer Oberflächentopographie in ein durch Polieren geglättetes Substrat eingesetzt.

Dem Ätzen geht das photolithographische Maskieren voraus, dass vorzugsweise die beiden nachfolgenden Schritte umfasst:
- gleichmäßiges Auftragen von strahlungsempfindlichen Lack auf die optisch wirksame Oberflächentopographie sowie
- Ausbacken der mit strahlungsempfindlichen Lack beschichteten, optisch wirksamen Oberflächentopographie, wobei das Ausbacken ein Verdampfen des Lösungsmittels im Lack bewirkt.

Um den strahlungsempfindlichen Lack gleichmäßig auf die optisch wirksame Oberflächentopographie aufzutragen, ist es nach einer Ausgestaltung der Erfindung vorgesehen, dass der Lack mittels des an sich bekannten Spin-Coating-Verfahrens oder durch Aufsprühen aufgetragen wird.

Das erfindungsgemäße Verfahren ist insbesondere für Substrate geeignet, die sich durch plasmaunterstützte Ätzverfahren bearbeiten lassen, wie beispielsweise Quarz und Silizium. Mit dem Verfahren lassen sich insbesondere Zylinderlinsen für Hochleistungsdiodenlaser herstellen, die aufgrund der Abstrahlcharakteristik der Dioden eine hohe numerische Apertur benötigen, um das Licht zu kollimieren.

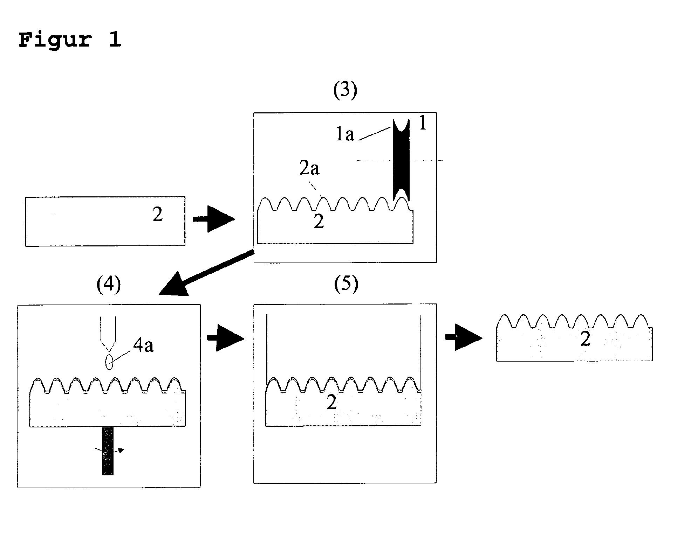

Nachfolgend wird das erfindungsgemäße Verfahren anhand des Schaubilds in Figur 1 näher erläutert:

Zunächst wird ein Schleifwerkzeug 1 hergestellt, dessen Schleiffläche 1a als Negativform einer auf einem Substrat 2 herzustellenden Struktur einer Oberflächentopographie 2a entspricht. Zur Herstellung des Schleifwerkzeuges 1 kommen Verfahren in Betracht, mit denen sich in metallischen Werkstoffen Konturen mit Formgenauigkeiten kleiner als 1 µm erzeugen lassen. Diese Formgenauigkeit ist erforderlich, damit das herzustellende Linsenarray in der geforderten Toleranz liegt. Geeignet ist beispielsweise die Mikrofunkenerosion oder auch eine Kombination aus Diamantdrehen und galvanischer Beschichtung des Schleifwerkzeugs 1.

In dem ersten Verfahrensschritt wird die Negativform 1a des Werkzeugs 1 durch Schleifen (3) in mehreren Reihen auf ein Substrat 2 aus Quarzglas übertragen. Die Verwendung von Schleifflächen 1a mit feinkörnigen Abrasivmedien, beispielsweise einer Diamantkörnung mit einer mittleren Körnung von 7 µm, gewährleistet eine geringe Schädigung während der Herstellung der optisch wirksamen Oberflächentopographie 2a.

In dem Endbearbeitungsschritt wird die im ersten Schritt erzeugte Oberflächentopographie 2 a geglättet, in dem sie zunächst fotolithografisch maskiert (4) und anschließend durch reaktives Ionenätzen(5) geglättet wird.

Die Maskierung umfasst das Auftragen des strahlungsempfindlichen Photoresistlacks 4a im Spin-Coating-Verfahren (4) auf das Substrat 2. Anschließend wird der Photoresistlack 4a in einem nicht dargestellten Ofen bei einer Temperatur von etwa 150° - 200 °C ausgebacken. Ggf. wird der Photoresistlack belichtet. Eine lokale Belichtung des Photoresistlacks und ein anschließender Entwicklungsschritt kann zur Anpassung bzw. Optimierung der Profilform der Mikrostruktur eingesetzt werden.

Die aufgebrachte Photoresistlackschicht wird auch als Maske bezeichnet.

An die Maskierung schließt sich das reaktive Ionenätzen (RIBE) (5) an, um die optisch wirksame Oberflächentopographie zu glätten, ohne deren Kontur zu verändern. Im Gegensatz zum Ionenstrahlätzen wird beim reaktiven Ionenätzen das Substrat 2 vollflächig bearbeitet, so dass während des reaktiven Ionenätzens (5) die gesamte optisch wirksame Oberflächentopographie (2 a) gleichzeitig bestrahlt wird.

Die Atome von der Photoresistlackschicht und dem darunterliegenden Substrat werden durch das Ionenätzen abgetragen und etwaige Defekte in der Oberflächentopographie des Substrats geglättet.

Besonders anspruchsvoll ist das erfindungsgemäße Verfahren bei der Herstellung von optisch wirksamen Oberflächentopographien mit großen Strukturhöhen von 0,3 mm. Bei derartigen Strukturhöhen ist der gleichmäßige Auftrag des strahlungsempfindlichen Lacks von entscheidender Bedeutung, da eine ungleichmäßige Lackverteilung eine ungleichmäßige Glättung nach sich zieht. Das Spin-Coating-Verfahren begünstigt die gleichmäßige Verteilung des Lacks, der in Schichtdicken zwischen 1 und 10 µm aufgetragen wird, entscheidend. Bei dem Spin-Coating-Verfahren wird der Lack durch eine Drehung des Substrats 2 (vgl (4)) vom Zentrum an den Rand geschleudert.

Zur weiteren Verbesserung der Verteilung des Lacks, insbesondere bei einer Oberflächentopographie mit großen Strukturhöhen, kann die Oberflächentopographie 2 a eine sternförmige Struktur aufweisen (d.h. die einzelnen Strukturen verlaufen radial vom Zentrum zum Rand des Substrats). Hierdurch wird der hohen Strukturhöhe entgegengewirkt, die bei einer Anordnung der Strukturen entsprechend Figur 1 einer gleichmäßigen Verteilung des Lacks entgegenwirken kann. Eine alternative Lösung besteht darin, den Lack aufzusprühen.

## Patentansprüche

1. Verfahren zur Herstellung optisch wirksamer Mikrostrukturen, insbesondere von Linsen, Linsenarrays und Prismen, bei dem in mindestens einem Schritt eine optisch wirksame Oberflächentopographie auf einem Substrat durch ein mechanisches Verfahren erzeugt wird und in mindestens einem weiteren Endbearbeitungsschritt die Oberflächentopographie geglättet wird, **dadurch gekennzeichnet, dass** die optisch wirksame Oberflächentopographie (2 a) fotolithographisch maskiert und durch Ätzen (5) geglättet wird.

2. Verfahren nach Anspruch 1, **dadurch gekennzeichnet, dass** die optisch wirksame Oberflächentopographie (2 a) durch plasmaunterstütztes Trockenätzen, insbesondere Plasmaätzen oder reaktives Ionenätzen geglättet wird.

3. Verfahren nach Anspruch 1 oder 2, **dadurch gekennzeichnet, dass** das photolithographische Maskieren (4) folgende aufeinanderfolgende Schritte umfasst:
- gleichmäßiges Auftragen von strahlungsempfindlichen Lack (4 a) auf die optisch wirksame Oberflächentopographie (2 a) sowie
- Ausbacken der mit strahlungsempfindlichen Lack (4 a) beschichteten, optisch wirksamen Oberflächentopographie (2 a), wobei das Ausbacken ein Verdampfen des Lösungsmittels im Lack (4 a) bewirkt.

4. Verfahren nach Anspruch 3, **dadurch gekennzeichnet, dass** die mit strahlungsempfindlichen Lack (4 a) beschichtete optisch wirksame Oberflächentopographie (2 a) vor oder nach dem Ausbacken belichtet wird.

5. Verfahren nach einem der Ansprüche 1 bis 4, **dadurch gekennzeichnet, dass** zur Erzeugung der optisch wirksamen Oberflächentopographie (2 a) als mechanisches Verfahren abbildendes Schleifen oder Ultraschallschwingläppen oder Laserabtragen zum Einsatz gelangt.

6. Verfahren nach einem der Ansprüche 1 bis 5, **dadurch gekennzeichnet, dass** zur Herstellung optisch wirksamer Mikrostrukturen Substrate (2) aus Quarz oder Silizium eingesetzt werden.

7. Verfahren nach einem der Ansprüche 1 bis 6, **dadurch gekennzeichnet, dass** während des plasmaunterstützten Trockenätzens, insbesondere Plasmaätzens oder reaktiven Ionenätzens (5) die gesamte optisch wirksame Oberflächentopographie (2 a) gleichzeitig bestrahlt wird.

8. Verfahren nach einem der Ansprüche 3 bis 7, **dadurch gekennzeichnet, dass** der strahlungsempfindliche Lack (4 a) auf die optisch wirksame Oberflächentopographie (2 a) mittels des an sich bekannten Spin-Coating-Verfahrens oder durch Aufsprühen aufgetragen wird.
